# EUROPEAN PATENT APPLICATION

(11) **EP 3 232 519 A1**
(43) Date of publication of application: **18.10.2017**
(21) Application number: 17163964.4
(22) Date of filing: 30.03.2017
(51) Int. Cl.: H01R 31/06

(54) **POWER INTERFACE DEVICE**

(30) Priority: 15.04.2016 TW 105111756; 08.11.2016 TW 105136210
(71) Applicant: Yue, Steven, Taipei City 11463 (TW)
(72) Inventor: Yue, Steven, Taipei City 11463 (TW)
(74) Representative: Desormiere, Pierre-Louis

(57) **Abstract**

A power interface device (1) includes a first connecting module (11), a second connecting module (12) and a processing module (10) . The processing module (10) performs the following: receiving a supply voltage (VCC1) through the first connecting module (11) from a power supply device (5) that employs a fast charging technology and that provides, based on an informing output, the supply voltage (VCC1) having a magnitude dependent on the informing output; generating the informing output; outputting the informing output to the power supply device (5) through the first connecting module (11); and starting to output the supply voltage (VCC1) to the second connecting module (12) when determining that a condition associated with the magnitude of the supply voltage (VCC1) is met.

## Description

### Background of the invention

The disclosure relates to a power interface device, and more particularly to a power interface device for delivering power from a power supply device to a battery-less power consuming device.

Fast charging technology (e.g., Quick Charge 2.0 technology) is widely used in devices such as a charging device and a rechargeable device. A charging device that employs the fast charging technology may be, for example, a power bank that provides a supply voltage of 5V, 9V or 12V. A rechargeable device that employs the fast charging technology may be, for example, a rechargeable battery of a mobile phone that can be charged by the supply voltage of 5V, 9V or 12V. Conventionally, the fast charging technology is used only for charging purposes.

Moreover, when the rechargeable battery of the mobile phone is coupled to and fully charged by the power bank, the power bank waits for 8 to 15 seconds and then goes into sleep mode to stop providing the supply voltage, thereby saving power or preventing overcharging. Thereafter, in order to wake up the power bank to provide the supply voltage again, the rechargeable battery of the mobile phone has to be decoupled from and then coupled back to the power bank. Therefore, for the following reasons, it is inconvenient to use the power bank to power a power consuming device that is battery-less and that requires continuous external power supply for operation:
1. Once the power bank goes into sleep mode while the power consuming device is coupled thereto (e.g., the power consuming device is turned off when coupled to the power bank), the power consuming device has to be decoupled from and then coupled back to the power bank so as to wake up the power bank.
2. If the power consuming device is not turned on within 8 to 15 seconds starting from each instance the power bank wakes up, the power bank will go into sleep mode again.

### Object and summary of the invention

Therefore, an object of the disclosure is to provide a power interface device that can alleviate at least one of the drawbacks of the prior art.

According to the disclosure, the power interface device is operatively associated with a power supply device that employs fast charging technology and that provides, based on an informing output, a supply voltage having a magnitude dependent on the informing output. The power interface device includes a first connecting module, a second connecting module and a processing module. The first connecting module is used to be coupled to the power supply device. The processing module is coupled to the first connecting module for receiving the supply voltage from the power supply device therethrough, and is coupled further to the second connecting module. The processing module generates the informing output, and outputs the informing output to the power supply device through the first connecting module. The processing module starts to output the supply voltage to the second connecting module when determining that a condition associated with the magnitude of the supply voltage is met.

### Brief description of the drawings

Other features and advantages of the disclosure will become apparent in the following detailed description of the embodiments with reference to the accompanying drawings, of which:
Fig. 1 is a block diagram illustrating a first embodiment of a power interface device according to the disclosure in use with a power supply device and a power consuming device;
Fig. 2 is a circuit diagram illustrating the first embodiment;
Fig. 3 is an exemplary perspective view of the first embodiment;
Fig. 4 is another exemplary perspective view of the first embodiment;
Fig. 5 is a circuit diagram illustrating a second embodiment of the power interface device according to the disclosure;
Fig. 6 is a flow chart illustrating a method performed by the second embodiment;
Fig. 7 is a circuit diagram illustrating a third embodiment of the power interface device according to the disclosure; and
Fig. 8 is a circuit diagram illustrating a fourth embodiment of the power interface device according to the disclosure.

### Detailed description of embodiments

Before the disclosure is described in greater detail, it should be noted that where considered appropriate, reference numerals or terminal portions of reference numerals have been repeated among the figures to indicate corresponding or analogous elements, which may optionally have similar characteristics.

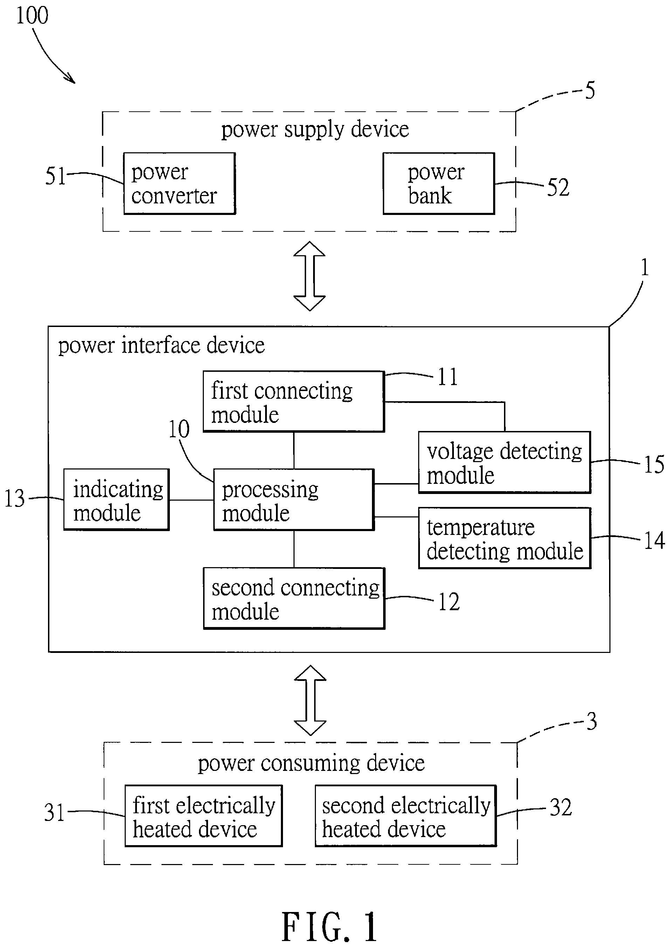

Referring to Fig. 1, a first embodiment of a power interface device 1 according to the disclosure is operatively associated with a power supply device 5 and a power consuming device 3.

The power supply device 5 employs fast charging technology, receives an informing output of the power interface device 1, and provides, based on the informing output, a supply voltage having a magnitude dependent on the informing output. In this embodiment, the power supply device 5 may be one of a power converter 51 and a power bank 52 that employ Quick Charge (QC) 2.0 technology. The power converter 51 receives an alternating current (AC) grid voltage and the informing output, and performs AC-to-DC (direct current) conversion upon the AC grid voltage based on the informing output to generate the supply voltage having the magnitude of 5V, 9V or 12V. The power bank 52 receives the informing output, and generates, based on the informing output, the supply voltage having the magnitude of 5V, 9V or 12V.

The power consuming device 3 is battery-less. In this embodiment, the power consuming device 3 may be one of a first electrically heated device 31 (which is designed to be powered by a voltage having a magnitude of 9V) and a second electrically heated device 32 (which is designed to be powered by a voltage having a magnitude of 12V) . Each of the first and second electrically heated devices 31, 32 may be in a form of, for example, a garment, a blanket, a shoe, or the like.

The power interface device 1 of this embodiment is an adapter, and includes a first connecting module 11, a second connecting module 12, a temperature detecting module 14, a voltage detecting module 15, a processing module 10 and an indicating module 13.

The first connecting module 11 is used to be coupled to the power supply device 5. The second connecting module 12 is used to be coupled to the power consuming device 3.

The temperature detecting module 14 detects a temperature of the power supply device 5, and generates a temperature detection signal that indicates the temperature of the power supply device 5.

The voltage detecting module 15 is coupled to the first connecting module 11, detects the supply voltage from the power supply device 5 through the first connecting module 11, and generates a voltage detection signal that indicates a magnitude of the supply voltage.

The processing module 10 is coupled to the first connecting module 11 for receiving the supply voltage from the power supply device 5 therethrough, coupled further to the second connecting module 12, and coupled further to the temperature detecting module 14 and the voltage detecting module 15 for receiving the temperature detection signal and the voltage detection signal respectively therefrom. The processing module 10 is operable by a user to generate a setting signal that indicates a user desired magnitude of the supply voltage, generates the informing output based on the setting signal, and outputs the informing output to the power supply device 5 through the first connecting module 11. Based on the temperature detection signal, the voltage detection signal and the setting signal, the processing module 10 selectively outputs the supply voltage to power the power consuming device 3 through the second connecting module 12, and generates an indication signal that indicates whether or not the supply voltage is outputted thereby.

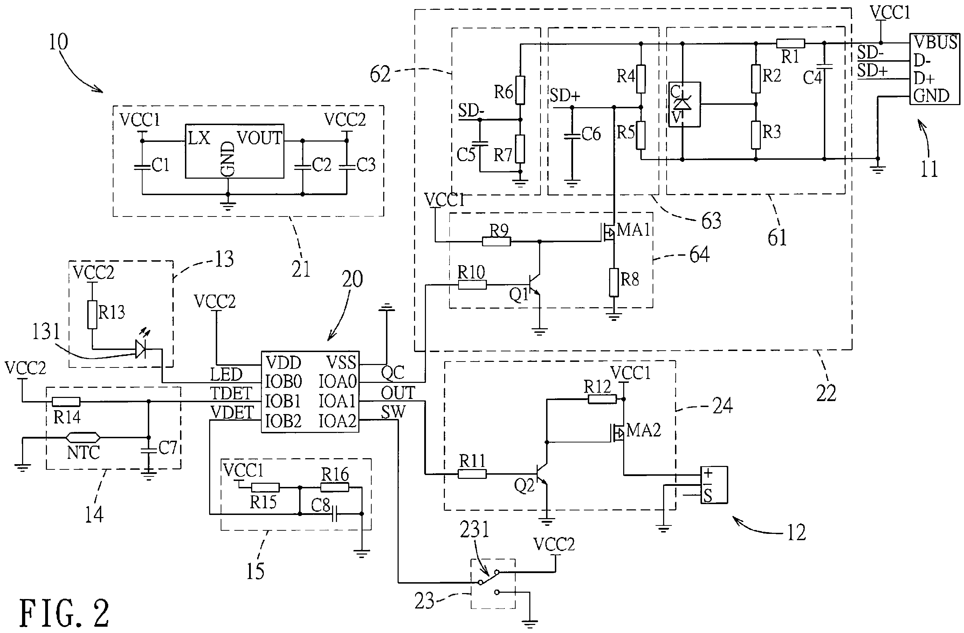

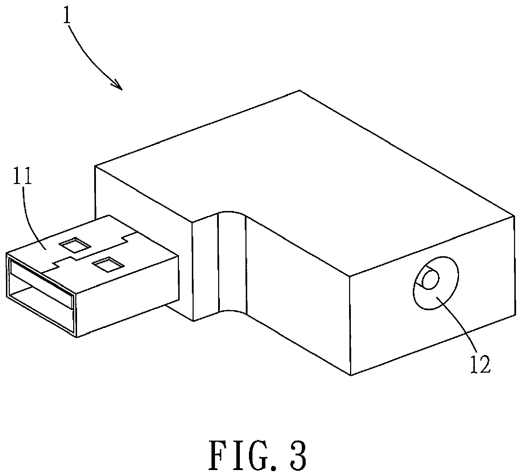

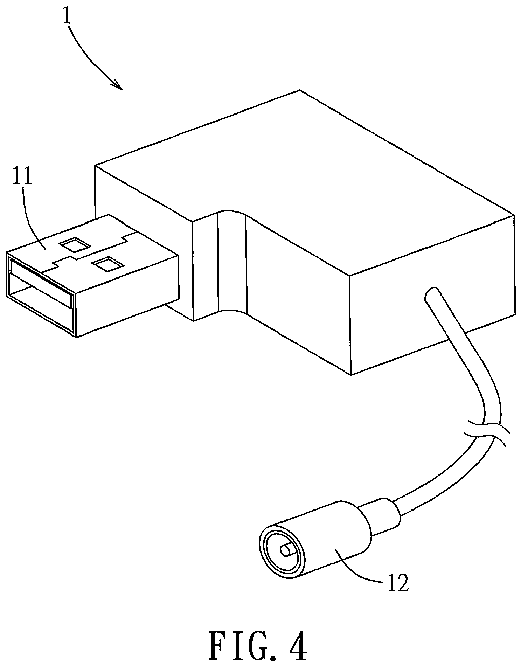

Referring to Figs. 1 and 2, in this embodiment, the first connecting module 11 is a universal serial bus (USB) plug having a power terminal (VBUS), a negative data terminal (D-), a positive data terminal (D+) and a ground terminal (GND) that are used to be coupled to the power supply device 5. The second connecting module 12 is a DC power jack having a first terminal (+), a second terminal (-) and a third terminal (S) that are used to be coupled to the power consuming device 3. It should be noted that, as shown in Fig. 3, both the first and second connecting modules 11, 12 may be disposed on a housing of the power interface device 1. Alternatively, as shown in Fig. 4, the first connecting module 11 may be disposed on the housing of the power interface device 1, and the second connecting module 12 may be disposed on an end of a cable extending from the housing of the power interface device 1.

In this embodiment, the temperature detecting module 14 includes a thermistor (NTC) and other elements. The thermistor (NTC) contacts the first connecting module 11, and has a resistance that varies according to the temperature of the power supply device 5. The temperature detecting module 14 generates the temperature detection signal (TDET) based on the resistance of the thermistor (NTC).

In this embodiment, the voltage detecting module 15 is coupled to the power terminal (VBUS) of the first connecting module 11 for receiving the supply voltage (VCC1) from the power supply device 5 therethrough, and divides the supply voltage (VCC1) to generate the voltage detection signal (VDET).

In this embodiment, the processing module 10 includes a voltage regulating circuit 21, an informing circuit 22, a switching circuit 23, an output circuit 24 and a control circuit 20.

The voltage regulating circuit 21 is coupled to the power terminal (VBUS) of the first connecting module 11 for receiving the supply voltage (VCC1) from the power supply device 5 therethrough, and is coupled further to the temperature detecting module 14. The voltage regulating circuit 21 regulates the supply voltage (VCC1) to generate a first internal voltage (VCC2) having a magnitude of 5V, and outputs the first internal voltage (VCC2) to power the temperature detecting module 14.

The informing circuit 22 is coupled to the power terminal (VBUS) of the first connecting module 11 for receiving the supply voltage (VCC1) from the power supply device 5 therethrough, is coupled further to the negative and positive data terminals (D-, D+) of the first connecting module 11, and further receives an informing control output. The informing circuit 22 generates the informing output based on the informing control output, and outputs the informing output to the power supply device 5 through the negative and positive data terminals (D-, D+) of the first connecting module 11.

In this embodiment, the informing control output includes an informing control signal (QC), and the informing output includes two informing signals (SD-, SD+). Moreover, the informing circuit 22 includes a regulating unit 61, a first dividing unit 62, a second dividing unit 63 and a division control unit 64.

The regulating unit 61 is coupled to the power terminal (VBUS) of the first connecting module 11 for receiving the supply voltage (VCC1) from the power supply device 5 therethrough, and regulates the supply voltage (VCC1) to generate a second internal voltage having a magnitude of 5V.

The first dividing unit 62 is coupled to the regulating unit 61 for receiving the second internal voltage therefrom, and is coupled further to the negative data terminal (D-) of the first connecting module 11. The first dividing unit 62 divides the second internal voltage to generate the informing signal (SD-) having a voltage magnitude of 0.6V, and outputs the informing signal (SD-) to the power supply device 5 through the negative data terminal (D-) of the first connecting module 11.

The second dividing unit 63 is coupled to the regulating unit 61 for receiving the second internal voltage therefrom, and is coupled further to the positive data terminal (D+) of the first connecting module 11. The second dividing unit 63 divides the second internal voltage to generate the informing signal (SD+) having a voltage magnitude of 0.6V or 3.3V, and outputs the informing signal (SD+) to the power supply device 5 through the positive data terminal (D+) of the first connecting module 11.

The division control unit 64 is coupled to the power terminal (VBUS) of the first connecting module 11 for being powered by the supply voltage (VCC1) from the power supply device 5 therethrough, is coupled further to the second dividing unit 63, and receives the informing control signal (QC). The division control unit 64 controls the voltage division of the second dividing unit 63 based on the informing control signal (QC), so the voltage magnitude of the informing signal (SD+) is associated with the informing control signal (QC).

In this embodiment, the division control unit 64 includes three resistors (R8, R9, R10) and two transistors (Q1, MA1). The resistor (R10) has a first terminal that receives the informing control signal (QC), and a second terminal. The transistor (Q1) (e.g., an NPN bipolar junction transistor (BJT)) has a first terminal (e.g., a collector terminal), a second terminal (e.g., an emitter terminal) that is grounded, and a control terminal (e. g. , a base terminal) that is coupled to the second terminal of the resistor (R10). The resistor (R9) is coupled between the power terminal (VBUS) of the first connecting module 11 and the first terminal of the transistor (Q1). The transistor (MA1) (e.g., a P-type metal oxide semiconductor field effect transistor (pMOSFET)) has a first terminal (e.g., a source terminal) that is coupled to the second dividing unit 63, a second terminal (e.g., a drain terminal), and a control terminal (e.g., a gate terminal) that is coupled to the first terminal of the transistor (Q1). The resistor (R8) is coupled between the second terminal of the transistor (MA1) and ground. When the informing control signal (QC) is at a logic low level, both the transistors (Q1, MA1) do not conduct, the resistor (R8) does not take part in the voltage division of the second dividing unit 63, and the voltage magnitude of the informing signal (SD+) is 3.3V. When the informing control signal (QC) is at a logic high level, both the transistors (Q1, MA1) conduct, the resistor (R8) takes part in the voltage division of the second dividing unit 63, and the voltage magnitude of the informing signal (SD+) is 0.6V.

According to the QC 2.0 technology, the power supply device 5 may provide the supply voltage (VCC1) having the magnitude of 9V when the voltage magnitudes of the informing signals (SD-, SD+) are respectively 0.6V and 3.3V, and may provide the supply voltage (VCC1) having the magnitude of 12V when the voltage magnitudes of the informing signals (SD-, SD+) are both 0.6V.

The switching circuit 23 is operable in a plurality of states, and generates the setting signal (SW) based on a current operating state thereof. In this embodiment, the switching circuit 23 is switchable between a first state and a second state, and includes a single-pole, double-throw (SPDT) switch 231 having a first terminal that is grounded, a second terminal that provides the setting signal (SW), and a third terminal that receives a predetermined non-zero voltage (e.g., the first internal voltage (VCC2)). When the switching circuit 23 operates in the first state, the SPDT switch 231 connects the second and third terminals thereof, so the setting signal (SW) has a voltage magnitude of 5V (i.e., being at a logic high level). When the switching circuit 23 operates in the second state, the SPDT switch 231 connects the first and second terminals thereof, so the voltage magnitude of the setting signal (SW) is zero (i.e., being at a logic low level).

The output circuit 24 is coupled to the power terminal (VBUS) of the first connecting module 11 for receiving the supply voltage (VCC1) from the power supply device 5 therethrough, is coupled further to the first terminal (+) of the second connecting module 12, and further receives an output control signal (OUT). The output circuit 24 is operable, based on the output control signal (OUT), to output the supply voltage (VCC1) to the power consuming device 3 through the first terminal (+) of the second connecting module 12.

In this embodiment, the output circuit 24 includes two resistors (R11, R12) and two transistors (Q2, MA2). The resistor (R11) has a first terminal that receives the output control signal (OUT), and a second terminal. The transistor (Q2) (e.g., an NPN BJT) has a first terminal (e.g., a collector terminal), a second terminal (e.g., an emitter terminal) that is grounded, and a control terminal (e.g., a base terminal) that is coupled to the second terminal of the resistor (R11). The resistor (R12) is coupled between the power terminal (VBUS) of the first connecting module 11 and the first terminal of the transistor (Q2). The transistor (MA2) (e.g., a pMOSFET) has a first terminal (e.g., a source terminal) that is coupled to the power terminal (VBUS) of the first connecting module 11, a second terminal (e.g., a drain terminal) that is coupled to the first terminal (+) of the second connecting module 12, and a control terminal (e.g., a gate terminal) that is coupled to the first terminal of the transistor (Q2). When the output control signal (OUT) is at a logic low level, both the transistors (Q2, MA2) do not conduct, and the supply voltage (VCC1) is not outputted through the transistor (MA2). When the output control signal (OUT) is at a logic high level, both the transistors (Q2, MA2) conduct, and the supply voltage (VCC1) is outputted through the transistor (MA2).

The control circuit 20 (e.g., having a model name of AT8PC713AM) is coupled to the voltage regulating circuit 21 for being powered by the first internal voltage (VCC2) therefrom, is coupled further to the temperature detecting module 14, the voltage detecting module 15 and the second terminal of the SPDT switch 231 for receiving the temperature detection signal (TDET), the voltage detection signal (VDET) and the setting signal (SW) respectively therefrom, and is coupled further to the first terminals of the resistors (R10, R11).

The control circuit 20 generates, based on the setting signal (SW), the informing control signal (QC) for controlling the informing circuit 22. In this embodiment, when the setting signal (SW) is at the logic high level, the control circuit 20 sets the informing control signal (QC) to the logic low level, so the power supply device 5 may provide the supply voltage (VCC1) having the magnitude of 9V; and when the setting signal (SW) is at the logic low level, the control circuit 20 sets the informing control signal (QC) to the logic high level, so the power supply device 5 may provide the supply voltage (VCC1) having the magnitude of 12V.

Based on the temperature detection signal (TDET), the voltage detection signal (VDET) and the setting signal (SW), the control circuit 20 generates the output control signal (OUT) for controlling the output circuit 24, and the indication signal (LED) that indicates whether or not the supply voltage (VCC1) is outputted by the output circuit 24. The control circuit 20 determines, based on the setting signal (SW), whether the magnitude of the supply voltage (VCC1) should be 9V or 12V. When the setting signal (SW) is at the logic high level, it is determined that the magnitude of the supply voltage (VCC1) should be 9V. When the setting signal (SW) is at the logic low level, it is determined that the magnitude of the supply voltage (VCC1) should be 12V. Initially, the control circuit 20 sets the output control signal (OUT) to the logic low level, so the output circuit 24 does not output the supply voltage (VCC1). Thereafter, when determining that the magnitude of the supply voltage (VCC1) indicated by the voltage detection signal (VDET) is within a voltage range dependent on the setting signal (SW) (a first condition), the control circuit 20 sets the output control signal (OUT) to the logic high level, so the output circuit 24 starts to output the supply voltage (VCC1). For example, the voltage range may be between 8.5V to 9.5V when it is determined based on the setting signal (SW) (which is at the logic high level) that the magnitude of the supply voltage (VCC1) should be 9V, and may be between 11.5V and 12.5V when it is determined based on the setting signal (SW) (which is at the logic low level) that the magnitude of the supply voltage (VCC1) should be 12V. Thereafter, when determining that the temperature of the power supply device 5 as indicated by the temperature detection signal (TDET) exceeds a predetermined temperature value (a second condition, where the predetermined temperature value may be 50°C for example), the control circuit 20 sets the output control signal (OUT) to the logic low level, so the output circuit 24 stops outputting the supply voltage (VCC1). Since the supply voltage (VCC1) is not outputted by the output circuit 24 when the magnitude of the supply voltage (VCC1) deviates too much from its expected value or when the temperature of the power supply device 5 is too high, safe power usage can be achieved.

The indicating module 13 is coupled to the control circuit 20 for receiving the indication signal (LED) therefrom, and provides an indication according to the indication signal (LED). In this embodiment, the indicating module 13 includes a light emitting diode 131. When the indication signal (LED) indicates that the supply voltage (VCC1) is outputted by the output circuit 24, the light emitting diode 131 emits light constantly. When the indication signal (LED) indicates that the supply voltage (VCC1) is not outputted by the output circuit 24, the light emitting diode 131 flickers to inform the user of a possible occurrence of problem.

It should be noted that the operating state of the switching circuit 23 may be set by a user. When the first electrically heated device 31 (which is designed to be powered by a voltage having the magnitude of 9V) is used as the power consuming device 3, the user can set the switching circuit 23 to operate in the first state, so that the power supply device 5 may provide the supply voltage (VCC1) having the magnitude of 9V, and the power interface device 1 of this embodiment may output the supply voltage (VCC1) to power the power consuming device 3. When the second electrically heated device 32 (which is designed to be powered by a voltage having the magnitude of 12V) is used as the power consuming device 3, the user can set the switching circuit 23 to operate in the second state, so that the power supply device 5 may provide the supply voltage (VCC1) having the magnitude of 12V, and the power interface device 1 of this embodiment may output the supply voltage (VCC1) to power the power consuming device 3.

In view of the above, by virtue of the power interface device 1 of this embodiment that informs the power supply device 5 to adjust the magnitude of the supply voltage (VCC1), and that selectively outputs the supply voltage (VCC1) to the power consuming device 3, the power supply device 5 that employs the fast charging technology can be used to power the power consuming device 3 that is battery-less, and safe power usage can be achieved.

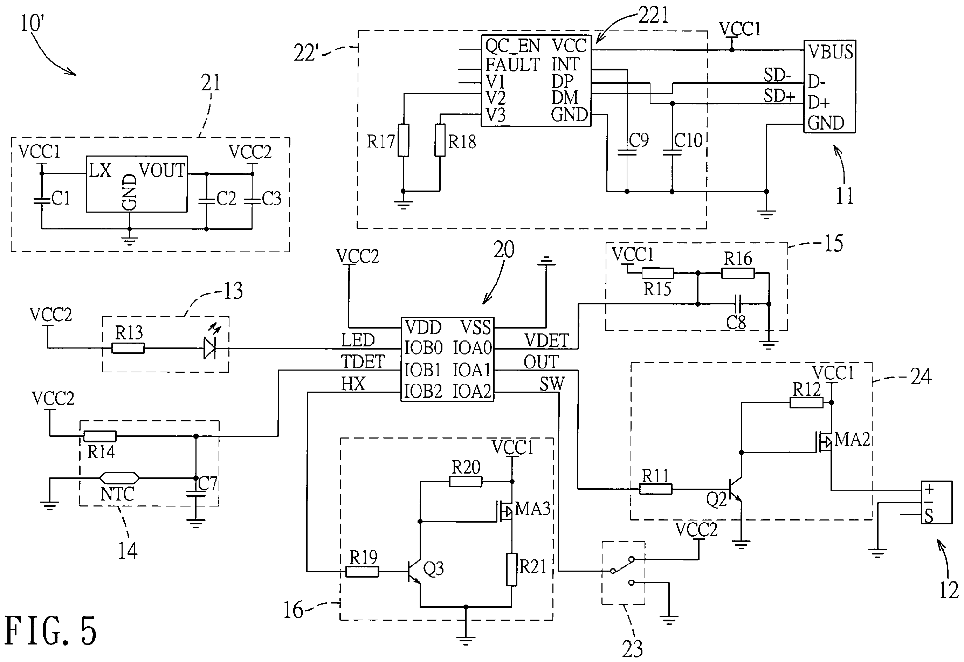

Referring to Figs. 1 and 5, a second embodiment of the power interface device 1 according to the disclosure is a modification of the first embodiment, and differs from the first embodiment in the processing module 10' .

In the second embodiment, in the processing module 10', the control circuit 20 does not generate the informing control signal (QC) (see Fig. 2); the connection of the informing circuit 22' to the control circuit 20 is omitted; and the informing circuit 22' is configurable in a plurality of states, and generates the informing output based on a current configuration state thereof.

In this embodiment, the informing circuit 22' is configurable in a first state and a second state, and includes at least one resistor, a processor 221 (e.g, having a model name of E357) and other elements. The processor 221 is coupled to the power terminal (VBUS) of the first connecting module 11 for being powered by the supply voltage (VCC1) from the power supply device 5 therethrough, and is coupled further to the negative and positive data terminals (D-, D+) of the first connecting module 11 and to the at least one resistor. The processor 221 generates the informing signal (SD-) having the voltage magnitude of 0.6V, generates, based on a number of the at least one resistor, the informing signal (SD+) having the voltage magnitude of 0.6V or 3.3V, and outputs the informing signals (SD-, SD+) to the power supply device 5 respectively through the negative and positive data terminals (D-, D+) of the first connecting module 11. When the informing circuit 22' is configured in the first state, two resistors (R17, R18) are included in the informing circuit 22', and the voltage magnitude of the informing signal (SD+) is 3.3V. When the informing circuit 22' is configured in the second state, only the resistor (R18) is included in the informing circuit 22' , and the voltage magnitude of the informing signal (SD+) is 0.6V.

It should be noted that, the configuration state of the switching circuit 23 may be set in a manufacturing phase. When the power interface device 1 of this embodiment is to be used with the first electrically heated device 31 which is designed to be powered by a voltage having the magnitude of 9V, the informing circuit 22' is configured in the first state, so the power supply device 5 may provide the supply voltage (VCC1) having the magnitude of 9V. When the power interface device 1 of this embodiment is to be used with the second electrically heated device 32 which is designed to be powered by a voltage having the magnitude of 12V, the informing circuit 22' is configured in the second state, so the power supply device 5 may provide the supply voltage (VCC1) having the magnitude of 12V.

Moreover, the processing module 10' further includes a prevention circuit 16 that is coupled to the power terminal (VBUS) of the first connecting module 11, and that is coupled further to the control circuit 20 for receiving a prevention control signal (HX) generated thereby. Based on the prevention control signal (HX), the prevention circuit 16 periodically (e.g., every 8 seconds) draws a current (which has a magnitude of, for example, 100mA) from the power supply device 5 through the power terminal (VBUS) of the first connecting module 11 for a predetermined time interval (e.g., 0.1 second) so as to prevent the power supply device 5 from going into sleep mode (where provision of the supply voltage (VCC1) is stopped).

In this embodiment, the prevention circuit 16 includes three resistors (R19, R20, R21) and two transistors (Q3, MA3). The resistor (R19) has a first terminal that is coupled to the control circuit 20 for receiving the prevention control signal (HX) therefrom, and a second terminal. The transistor (Q3) (e.g., an NPNBJT) has a first terminal (e.g., a collector terminal), a second terminal (e.g., an emitter terminal) that is grounded, and a control terminal (e.g., a base terminal) that is coupled to the second terminal of the resistor (R19). The resistor (R20) is coupled between the power terminal (VBUS) of the first connecting module 11 and the first terminal of the transistor (Q3). The transistor (MA3) (e.g., a pMOSFET) has a first terminal (e.g., a source terminal) that is coupled to the power terminal (VBUS) of the first connecting module 11, a second terminal (e.g., a drain terminal), and a control terminal (e.g., a gate terminal) that is coupled to the first terminal of the transistor (Q3). The resistor (R21) is coupled between the second terminal of the transistor (MA3) and ground. When the prevention control signal (HX) is at a logic low level, both the transistors (Q3, MA3) do not conduct, and the resistor (R21) does not draw the current from the power supply device 5 through the power terminal (VBUS) of the first connecting module 11 and the transistor (MA3). When the prevention control signal (HX) is at a logic high level, both the transistors (Q3, MA3) conduct, and the resistor (R21) draws the current from the power supply device 5 through the power terminal (VBUS) of the first connecting module 11 and the transistor (MA3).

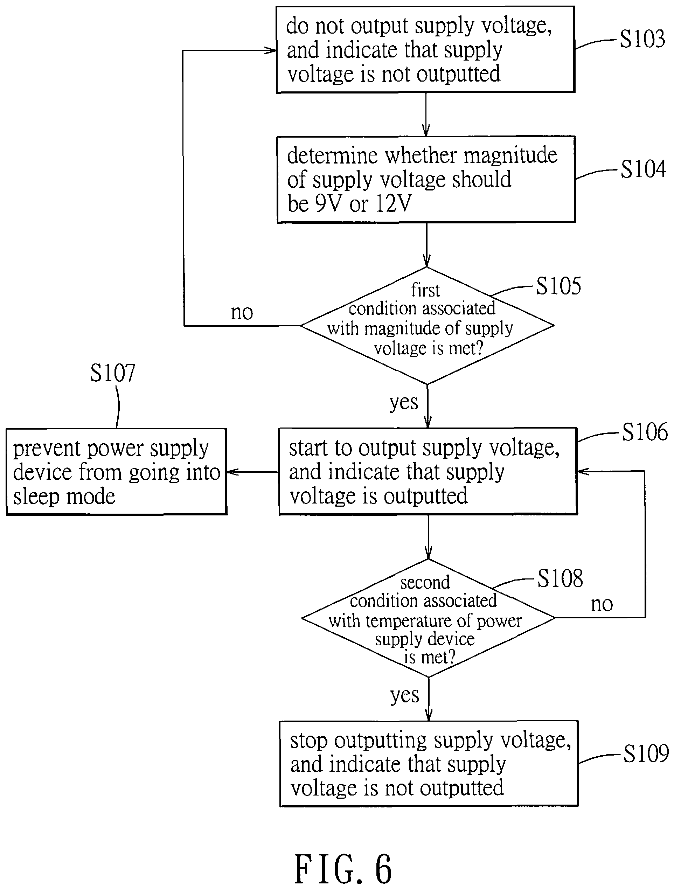

Referring to Figs. 1, 5 and 6, a method performed by the control circuit 20 includes the following steps (S103-S109).

In step (S103), the control circuit 20 controls the output circuit 24 to not output the supply voltage (VCC1), and controls the indicating module 13 to indicate that the supply voltage (VCC1) is not outputted by the output circuit 24.

In step (S104), the control circuit 20 determines, based on the setting signal (SW), whether the magnitude of the supply voltage (VCC1) should be 9V or 12V.

In step (S105), the control circuit 20 determines, based on the magnitude of the supply voltage (VCC1) indicated by the voltage detection signal (VDET) and the determination made in step (S104), whether the first condition is met or not. If it is determined in step (S104) that the magnitude of the supply voltage (VCC1) should be 9V, the first condition is met when the magnitude of the supply voltage (VCC1) indicated by the voltage detection signal (VDET) is within the voltage range of, for example, 8.5V to 9. 5V. If it is determined in step (S104) that the magnitude of the supply voltage (VCC1) should be 12V, the first condition is met when the magnitude of the supply voltage (VCC1) indicated by the voltage detection signal (VDET) is within the voltage range of, for example, 11.5V to 12.5V. If the determination made in (S105) is affirmative, the flow proceeds to step (S106). Otherwise, the flow goes back to step (S103).

In step (S106), the control circuit 20 controls the output circuit 24 to start outputting the supply voltage (VCC1), and controls the indicating module 13 to indicate that the supply voltage (VCC1) is outputted by the output circuit 24.

In step (S107), the control circuit 20 controls the prevention circuit 16 to periodically draw the current from the power supply device 5 for the predetermined time interval, so as to prevent the power supply device 5 from going into sleep mode (i. e. , ceasing the provision of the supply voltage (VCC1)).

In step (S108), the control circuit 20 determines, based on the temperature of the power supply device 5 as indicated by the temperature detection signal (TDET), whether the second condition is met or not. The second condition is met when the temperature of the power supply device 5 as indicated by the temperature detection signal (TDET) exceeds the predetermined temperature value (e.g., 50°C). If the determination made in (S108) is affirmative, the flowproceeds to step (S109). Otherwise, the flow goes back to step (S106).

In step (S109), the control circuit 20 controls the output circuit 24 to stop outputting the supply voltage (VCC1), and controls the indicating module 13 to indicate that the supply voltage (VCC1) is not outputted by the output circuit 24.

In view of the above, the power interface device 1 of this embodiment has the following advantages:
1. By virtue of the power interface device 1 that informs the power supply device 5 to adjust the magnitude of the supply voltage (VCC1), and that selectively outputs the supply voltage (VCC1) to the power consuming device 3, the power supply device 5 that employs the fast charging technology can be used to power the power consuming device 3 that is battery-less, and safe power usage can be achieved.
2. By virtue of the power interface device 1 that prevents the power supply device 5 from going into sleep mode, it is not necessary to wake up the power supply device 5. Therefore, it is convenient to use the power supply device 5 with the power consuming device 3 that is battery-less.

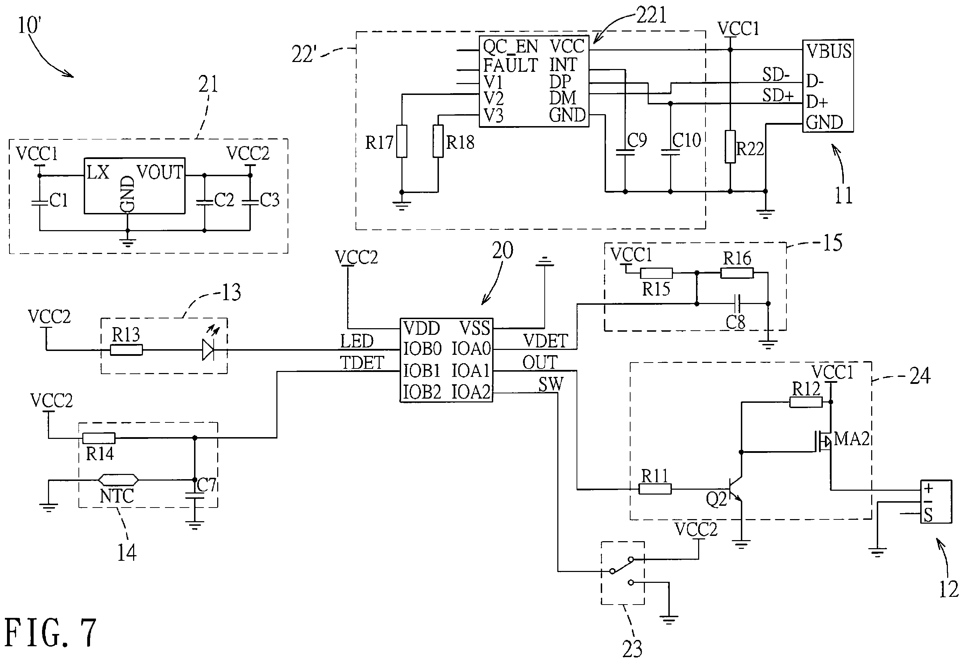

Referring to Figs. 1 and 7, a third embodiment of the power interface device 1 according to the disclosure is a modification of the second embodiment, and differs from the second embodiment in that a resistor (R22) is used in the processing module 10' to replace the prevention circuit 16 (see Fig. 5).

In the third embodiment, the control circuit 20 does not generate the prevention control signal (HX) (see Fig. 5); and the resistor (R22) is coupled between the power terminal (VBUS) of the first connecting module 11 and ground, and draws a current from the power supply device 5 through the power terminal (VBUS) of the first connecting module 11 so as to prevent the power supply device 5 from going into sleep mode (i.e., ceasing the provision of the supply voltage (VCC1)).

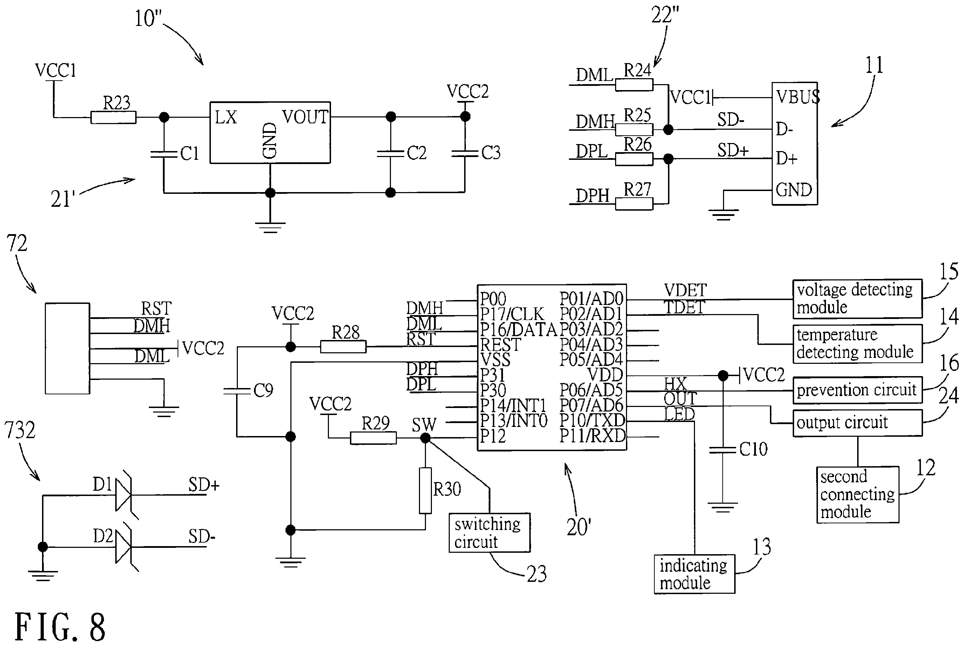

Referring to Figs. 1 and 8, a fourth embodiment of the power interface device 1 according to the disclosure is a modification of the second embodiment, and differs from the second embodiment in the processing module 10".

In the fourth embodiment, the magnitude of the first internal voltage (VCC2) is 3. 3V; the informing control output includes four informing control signals (DML, DMH, DPL, DPH) ; the informing circuit 22" generates the informing signal (SD-) based on the informing control signals (DML, DMH), and generates the informing signal (SD+) based on the informing control signals (DPL, DPH) ; and the control circuit 20' (e.g., having a model name of N79E715) is writable.

Moreover, the processing module 10" further includes a connector 72 and a protection circuit 732. The connector 72 is coupled to the control circuit 20', and is used to be coupled to a host (not shown) . Data (e. g. , a program to be executed by the control circuit 20') are written into the control circuit 20' by the host through the connector 72. The protection circuit 732 is coupled to common nodes between the informing circuit 22" and the first connecting module 11 (i.e., the terminals (D+, D-)), and suppresses voltage spikes induced on the common nodes so as to protect the control circuit 20'.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects.

While the disclosure has been described in connection with what are considered the exemplary embodiments, it is understood that the disclosure is not limited to the disclosed embodiments but is intended to cover various arrangements included within the spirit and scope of the broadest interpretation so as to encompass all such modifications and equivalent arrangements.

## Claims

1. A power interface device (1) operatively associated with a power supply device (5) that employs fast charging technology and that provides, based on an informing output, a supply voltage (VCC1) having a magnitude dependent on the informing output, said power interface device (1) **characterized by**:
a first connecting module (11) used to be coupled to the power supply device (5);
a second connecting module (12); and
a processing module (10) coupled to said first connecting module (11) for receiving the supply voltage (VCC1) from the power supply device (5) therethrough, and coupled further to said second connecting module (12), said processing module (10) generating the informing output, and outputting the informing output to the power supply device (5) through said first connecting module (11), said processing module (10) starting to output the supply voltage (VCC1) to said second connecting module (12) when determining that a first condition associated with the magnitude of the supply voltage (VCC1) is met.

2. The power interface device of claim 1, **characterized in that** said processing module (10) stops outputting the supply voltage (VCC1) to said second connecting module (12) when determining that a second condition associated with a temperature of the power supply device (5) is met.

3. The power interface device of claim 2, **characterized in that** the second condition is met when the temperature of the power supply device (5) exceeds a predetermined temperature value.

4. The power interface device of claim 1, **characterized in that** said processing module (10) further generates an indication signal (LED) that indicates whether or not the supply voltage (VCC1) is outputted thereby.

5. The power interface device of claim 4, further **characterized by** an indicating module (13) that is coupled to said processing module (10) for receiving the indication signal (LED) therefrom, and that provides an indication according to the indication signal (LED) .

6. The power interface device of claim 1, **characterized in that** said processing module (10) further generates a setting signal (SW), and the first condition is met when the magnitude of the supply voltage (VCC1) is within a voltage range dependent on the setting signal (SW).

7. The power interface device of claim 6, **characterized in that** said processing module (10) generates the informing output based on the setting signal (SW).

8. The power interface device of claim 6, **characterized in that** said processing module (10) includes:
a switching circuit (23) operable in a plurality of states, and generating the setting signal based on an operating state thereof;
an output circuit (24) coupled to said first connecting module (11) for receiving the supply voltage (VCC1) from the power supply device (5) therethrough, coupled further to said second connecting module (12), and operable to output the supply voltage (VCC1) to said second connecting module (12);
a control circuit (20) coupled to said switching circuit (23) for receiving the setting signal (SW) therefrom, and coupled further to said output circuit (24), said control circuit (20) generating, based on the setting signal (SW) and the magnitude of the supply voltage (VCC1), an output control signal (OUT) for controlling said output circuit (24) such that said output circuit (24) starts to output the supply voltage (VCC1) to said second connecting module (12) when the first condition is determined to be met; and
an informing circuit (22) coupled to said first connecting module (11), generating the informing output, and outputting the informing output to the power supply device (5) through said first connecting module (11).

9. The power interface device of claim 8, **characterized in that** said switching circuit (23) is switchable between a first state and a second state, and includes a single-pole, double-throw, SPDT, switch (231) having a first terminal that is grounded, a second terminal that provides the setting signal (SW), and a third terminal that receives a predetermined non-zero voltage,
when said switching circuit (23) operates in the first state, said SPDT switch (231) connecting said second and third terminals thereof,
when said switching circuit (23) operates in the second state, said SPDT switch (231) connecting said first and second terminals thereof.

10. The power interface device of claim 8, **characterized in that**:
said control circuit (20) further generates an informing control output based on the setting signal (SW); and
said informing circuit (22) is coupled further to said control circuit (20) for receiving the informing control output therefrom, and generates the informing output based on the informing control output.

11. The power interface device of claim 8, **characterized in that** said informing circuit (22) is configurable in a plurality of states, and generates the informing output based on a configuration state thereof.

12. The power interface device of claim 11, **characterized in that** said informing circuit (22') is configurable in a first state and a second state, and includes:
a number (N) of resistor (s), where N is a first number when said informing circuit (22') is configured in the first state, and where N is a second number that is different from the first number when said informing circuit (22') is configured in the second state; and
a processor (221) coupled to said first connecting module (11) and said resistor(s), generating the informing output based on the number (N), and outputting the informing output to the power supply device (5) through said first connecting module (11).

13. The power interface device of claim 8, **characterized in that** said processing module (10') further includes a resistor (R22) that is coupled to said first connecting module (11), and that draws a current from the power supply device (5) through said first connecting module (11) so as to prevent the power supply device (5) from ceasing provision of the supply voltage (VCC1).

14. The power interface device of claim 8, **characterized in that**:
said processing module (10') further includes a prevention circuit (16) that is coupled to said first connecting module (11), and that is operable to draw a current from the power supply device (5) through said first connecting module (11); and
said control module (20) is coupled further to said prevention circuit (16), and generates a prevention control signal (HX) for controlling said prevention circuit (16) such that said prevention circuit (16) periodically draws the current for a predetermined time interval so as to prevent the power supply device (5) from ceasing provision of the supply voltage (VCC1).

15. The power interface device of claim 8, **characterized in that**:
said control circuit (20') is writable;
said processing module (10") further includes a connector (72) that is coupled to said control circuit (20'); and
data are written into said control circuit (20') through said connector (72).

16. The power interface device of claim 8, **characterized in that** said processing module (10") further includes a protection circuit (732) that is coupled to at least one common node between said informing circuit (22") and said first connecting module (11), and that suppresses voltage spikes induced on said at least one common node.
